# EUROPÄISCHE PATENTSCHRIFT

(11) **EP 3 939 164 B1**
(45) Veröffentlichungstag und Bekanntmachung des Hinweises auf die Patenterteilung: **15.01.2025**
(21) Anmeldenummer: 20711126.1
(22) Anmeldetag: 11.03.2020
(51) Int. Cl.: H03K 17/975, H03K 17/98

(54) **ELEKTRISCHER MEHRWEGEKRAFTSENSOR**
ELECTRICAL MULTI-DIRECTIONAL FORCE SENSOR
CAPTEUR DE FORCE ÉLECTRIQUE MULTIVOIES

(30) Priorität: 13.03.2019 DE 102019001769
(43) Veröffentlichungstag der Anmeldung: 19.01.2022
(73) Patentinhaber: KOSTAL Automobil Elektrik GmbH & Co. KG, 58513 Lüdenscheid (DE)
(72) Erfinder: FEHLING, André, 59846 Sundern (DE); BLECKMANN, Michael, 58239 Schwerte-Ergste (DE); SEIFERT, Matthias, 44789 Bochum (DE); BRENSEL, Kai, 58454 Witten (DE); KAUL, Alexander, 58093 Hagen (DE); HUPERZ, Guido, 57462 Olpe (DE)
(74) Vertreter: Kerkmann, Detlef
(86) Internationale Anmeldenummer: PCT/EP2020/056469
(87) Internationale Veröffentlichungsnummer: WO 2020/182864

(56) Entgegenhaltungen:
- EP-A1- 3 279 761
- DE-A1- 102014 014 021
- US-A- 5 640 178
- US-A- 5 911 627

## Beschreibung

Die Erfindung betrifft einen elektrischen Mehrwegekraftsensor mit einem aus seiner Neutralstellung in zumindest zwei Betätigungsrichtungen verstellbaren Sensorzapfen, der sich bei Fortfall einer Betätigungskraft wieder in seine Neutralstellung zurückverlagert, mit einer Sensorplatte, die mit dem Sensorzapfen verbunden ist, und die durch eine Verstellung des Sensorzapfens gegen eine Leiterplatte verschwenkbar ist, die ein elektrisches Messsystem aufweist, dessen Ausgangssignal von der Position der Sensorplatte abhängt, wobei die Sensorplatte einstückig mit mehreren streifenförmigen Abstützelementen verbunden ist, die jeweils einen als Auge ausgebildeten Endabschnitt aufweisen.

Die nicht unmittelbar zur Leiterplatte gehörenden Komponenten des elektrischen Mehrwegekraftsensors werden nachfolgend als Sensorelement bezeichnet.

Ein derartiger Mehrwegekraftsensor ist aus der Druckschrift US 5 911 627 A bekannt. Die Druckschrift US 5 911 627 A beschreibt einen Steuerknüppel mit einem elektromagnetischen Element, das mit einem beweglichen Knüppel gekoppelt ist, und mit mindestens einem Paar orthogonaler Spulen auf einem darunter liegenden Substrat. Alternativ können die Spulen und elektromagnetischen Elemente umgekehrt sein. Die Bewegung des Stabs wird anhand der Überlappung des elektromagnetischen Elements und der Spulen in jeder Richtung erfasst. Der Qualitätsfaktor der Spule ändert sich mit zunehmender oder abnehmender Überlappung der Spule, was durch eine elektronische Schaltung gemessen werden kann, um die Bewegungsrichtung und das Ausmaß der Bewegung des Joysticks zu bestimmen. Das elektromagnetische Element kann z. B. eine leitende Stahlplatte, ein Stück eines anderen Metalls oder eines anderen leitenden Materials oder ein Ferritpartikel sein.

Mehrwegekraftsensoren werden insbesondere als Eingabeelemente, zum Beispiel bei Sitzverstellschaltern in Kraftfahrzeugen, verwendet. Eine Erfassungsvorrichtung in Form eines kapazitiven Mehrwegekraftsensors ist aus der deutschen Offenlegungsschrift DE 10 2014 014 021 A1 bekannt.

Der in der DE 10 2014 014 021 A1 beschriebene Mehrwegekraftsensor weist einen Sensorzapfen auf, der starr mit dem Oberteil eines Gehäuses verbunden ist. Im Inneren des Gehäuses ist der Sensorzapfen mit einer metallenen oder metallisierten Platte verbunden. Bei einer Verschwenkung des Sensorzapfens verschwenkt zugleich die Platte gegen metallisierte Flächen auf einer Leiterplatte, so dass sich die Kapazitätswerte von den durch die Anordnung von Platte und Flächen gebildeten Kondensatoren mit der Verschwenkbewegung des Sensorzapfens verändern. Da zum Verschwenken des Sensorzapfens zugleich das Oberteil des Gehäuses elastisch verformt werden muss, ist der Mehrwegekraftsensor recht steif, was für manche Anwendungen, wie zum Beispiel bei Sitzverstellschaltern, durchaus erwünscht ist.

Das Sensorelement des gemäß der Druckschrift DE 10 2014 014 021 A1 ausgeführten Mehrwegekraftsensor kann vorteilhaft ganz oder weitgehend als Spritzgießteil hergestellt werden, bei dem zumindest das Gehäuse und der Sensorzapfen einstückig aus einem Kunststoff bestehen. Eine Ausführung dieser Sensorelements vollständig aus Metall ist zwar auch möglich, aber aufgrund der schwierigen Entformbarkeit des Gehäuses mit einem vergleichsweise hohen Fertigungsaufwand verbunden. Für manche Anwendungen, insbesondere in Kraftfahrzeugen ist auch der relativ hohe Platzbedarf für das Gehäuse nachteilig.

Die europäische Patentanmeldung EP 3 279 761 A1 beschreibt eine Steuervorrichtung, die eine starre Basis, eine Kippfläche, sowie einen Kippbereich aufweist, der sich relativ zur starren Basis bei Kraftausübung relativ zur starren Basis bewegen kann, des Weiteren eine Scharniereinheit, die die Kippfläche mit der starren Basis verbindet, eine Eingabeeinheit, die mit dem Kippbereich verbunden ist, um eine Kraft auf den Kraft auf die Kippfläche auszuüben, und mindestens ein Sensorelement, welches vorgesehen ist, um eine Bewegung der Kippfläche zu erfassen.

Es stellte sich die Aufgabe, einen gattungsgemäßen besonders einfachen, kostengünstigen und kleinbauenden elektrischen Mehrwegekraftsensor mit einem einfachen, kostengünstigen, kleinbauenden und vollständig aus Metall bestehenden Sensorelement zu schaffen.

Diese Aufgabe wird erfindungsgemäß dadurch gelöst, dass die Sensorplatte und die Abstützelemente einstückig aus einer einzigen rechteckförmigen oder speziell quadratischen Metallplatte in den Richtungen der Diagonalen der Metallplattefreigeschnitten sind, so dass zwischen den streifenförmigen Abstützelementen so eine etwa kleeblattförmige Sensorplatte mit vier, einander jeweils paarweise gegenüberliegenden Sensorflügeln verbleibt.

Die Sensorplatte und die streifenförmigen Abstützelemente sind, vorzugsweise durch einen Stanzprozess, aus einer einzigen vorzugsweise rechteckförmigen oder speziell quadratischen Metallplatte freigeschnitten.

Zwischen den streifenförmigen Abstützelementen verbleibt so eine etwa kleeblattförmige Sensorplatte mit vier, einander jeweils paarweise gegenüberliegenden Sensorflügeln.

Die mit der Sensorplatte einstückig verbundenen streifenförmigen Abstützelemente ermöglichen eine besonders einfache Anordnung der Sensorplatte entweder an einem Anbauort gegenüber der Leiterplatte oder vorzugsweise auch direkt an der Leiterplatte.

Die Abstützelemente dienen dabei als Fixierelemente zur Befestigung der Sensorplatte und als Zentrierelemente zur positionsgenauen Ausrichtung der Sensorplatte. Hierzu bilden die Endabschnitte der Abstützelemente entweder Anschraubaugen oder Zentrieraugen aus, in die entsprechend entweder Schrauben oder Zentrierstifte eingesetzt werden.

Wenigsten zwei der Abstützelemente sind als Fixierelemente mit Anschraubaugen ausgeführt. Vorteilhaft ist es, wenn bei einem als Zentrierelement vorgesehenen Abstützelement das Zentrierauge als Langloch ausgeführt ist.

Durch mittiges Verbinden der Sensorplatte mit einem senkrecht abstehenden Sensorzapfen entsteht ein vollständiges Sensorelement. Da dieses keine schwer zu entformenden Teile, wie etwa ein Gehäuse aufweist, kann das Sensorelement auf einfache und kostengünstige Weise vollständig aus Metall gefertigt werden. Die Ausführung aus Metall begünstigt dabei eine besonders steife Ausführung eines Mehrwegkraftsensors, bei zugleich einfachem Aufbau. Das Sensorelement kann über seine Abstützelemente direkt mit der Leiterplatte verbunden werden. Auf der Leiterplatte sind elektrische Komponenten zur Erfassung von Verschwenkungen der Sensorplatte angeordnet. Das so gebildete Messsystem kann vorzugsweise aus mehreren auf der Leiterplatte angeordneten Leiterflächen bestehen, die mit den Sensorflügeln der Sensorplatte Kondensatoren ausbilden, deren Kapazitäten und Kapazitätsänderungen zur Bestimmung der Verstellung der Sensorplatte ermittelt werden können. Außer durch die Erfassung von Kapazitätswerten können die Abstandsänderungen aber auch durch andere Messprinzipien (zum Beispiel durch optische Verfahren) bestimmt werden.

Eine Verschwenkung des Sensorzapfens führt zu einer Verkippung der Sensorflügel der Sensorplatte relativ zu den Abstützelementen und somit zu einer Vergrößerung beziehungsweise Verkleinerung des Abstandes zwischen den Sensorflügeln und den auf der Leiterplatte angeordneten Leiterflächen. Die Größe der Abstandsänderungen ist dabei ein Maß für die eingebrachte Kraft, die durch eine hier nicht näher beschriebene Elektronik bestimmt werden kann.

Durch die Anordnung von vier Sensorflügeln wird gewährleistet, dass mit nur einem Sensorelement mindestens vier Betätigungsrichtungen erkannt werden können.

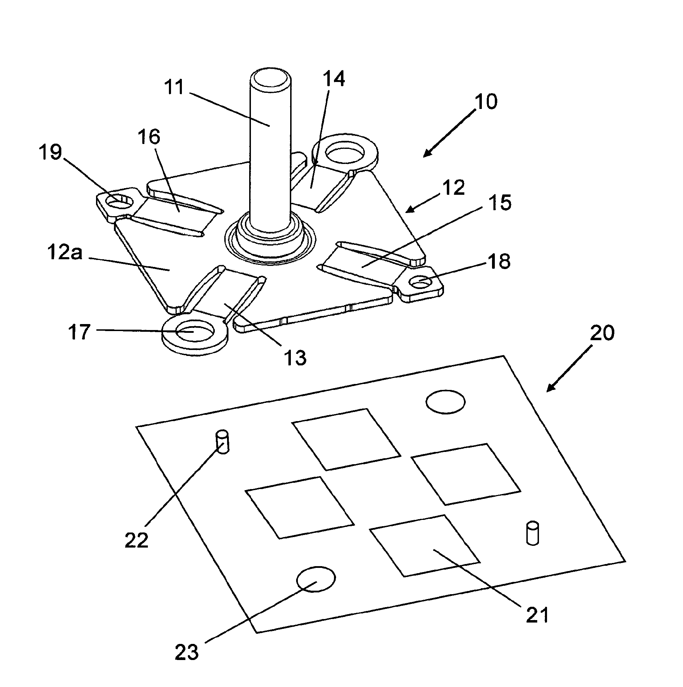

Nachfolgend soll ein Ausführungsbeispiel der Erfindung anhand der Zeichnung dargestellt und erläutert werden. Die einzige Figur zeigt eine Explosionsansicht eines erfindungsgemäß ausgeführten elektrischen Mehrwegekraftsensors.

Der dargestellte Mehrwegekraftsensor funktioniert nach einem kapazitiven Messprinzip und besteht aus einem metallenen Sensorelement 10 und aus einer Leiterplatte 20, auf der insbesondere mehrere Leiterflächen 21 aufgebracht sind.

Das Sensorelement 10 weist einen im Wesentlichen zylinderförmigen Sensorzapfen 11 auf. Mit dem unteren Endabschnitt des Sensorzapfens 11 ist eine metallene Sensorplatte 12 verbunden, die bei einem Verschwenken der Längsachse des Sensorzapfens 11 mit verschwenkt.

Hierdurch ändert sich die relative Lage der Sensorplatte 12 zu den auf der Leiterplatte 20 angeordneten Leiterflächen 21. Teile der Sensorplatte 12 bilden mit diesen Leiterflächen 21 Kondensatoren aus, deren Kapazitätswerte sich mit dem Verschwenken der Sensorplatte 12 verändern. Diese Kapazitätsänderungen können durch eine hier nicht dargestellte Elektronik ausgewertet werden, um die Lageänderung der Sensorplatte 12 und damit die auf den Sensorzapfen 11 wirkende Betätigungskraft zu ermitteln. Die Verschwenkung des Sensorzapfens 11 kann beispielsweise manuell mittels einer hier nicht dargestellten angefügten Knopfkappe erfolgen.

Der untere Teil des Sensorelements 10 ist aus einer ursprünglich quadratischen oder rechteckförmigen Metallplatte gefertigt, aus der in Richtung ihrer Diagonalen streifenförmige Abstützelemente 13, 14, 15, 16 freigeschnitten sind. Die Endabschnitte der Abstützelemente 13, 14, 15, 16 bilden Anschraubaugen 17 und Zentrieraugen 18, 19 aus. Die Zentrieraugen 18, 19, die zur Zentrierung des Sensorelements 10 dienen, sind als ein Loch 18 und ein Langloch 19 ausgeführt.

Der mit den streifenförmige Abstützelementen 13, 14, 15, 16 einstückig verbundene Teil der Metallplatte bildet eine etwa kleeblattförmige Sensorplatte 12 mit vier, einander paarweise gegenüberstehenden Sensorflügeln 12a aus, mit deren Zentrum der senkrecht abstehender, zylinderförmiger Sensorzapfen 11 fest verbunden ist.

Nach erfolgter Montage ist das Sensorelement 10 an der Oberseite der Leiterplatte 20 angeordnet, wobei die Anschraubaugen 17 durch Schrauben mit den Anschraublöcher 23 verbunden sind. Zur genauen Positionierung des Sensorelements 10 sind zudem die an der Oberseite der Leiterplatte 20 angeordneten Zentrierstifte 22 in die Zentrieraugen 18, 19 des Sensorelements 10 eingesetzt.

Die Sensorflügel 12a sind in der der Neutralstellung des Sensorelements 10 im Vergleich zu der Ebene, die durch die Abstützelemente 13, 14, 15, 16 aufgespannt wird, leicht nach oben abgewinkelt ausgerichtet, um in allen möglichen Verkippungsrichtungen eine Relativbewegung zu ermöglichen.

### Bezugszeichen

- 10: Sensorelement
- 11: Sensorzapfen
- 12: Sensorplatte
- 12a: Sensorflügel
- 13, 14, 15, 16: Abstützelemente
- 17: Anschraubaugen
- 18, 19: Zentrieraugen
- 18: Loch
- 19: Langloch
- 20: Leiterplatte
- 21: Leiterflächen
- 22: Zentrierstifte
- 23: Anschraublöcher

## Patentansprüche

1. Elektrischer Mehrwegekraftsensor mit einem aus seiner Neutralstellung in zumindest zwei Betätigungsrichtungen verstellbaren Sensorzapfen (11), der sich bei Fortfall einer Betätigungskraft wieder in seine Neutralstellung zurückverlagert,
mit einer Sensorplatte (12), die mit dem Sensorzapfen (11) verbunden ist, und die durch eine Verstellung des Sensorzapfens (11) gegen eine Leiterplatte (20) verschwenkbar ist, die ein elektrisches Messsystem aufweist, dessen Ausgangssignal von der Position der Sensorplatte (12) abhängt,
wobei die Sensorplatte (12) einstückig mit mehreren streifenförmigen Abstützelementen (13, 14, 15, 16) verbunden ist, die jeweils einen als Auge (17, 18, 19) ausgebildeten Endabschnitt aufweisen,
**dadurch gekennzeichnet,**
**dass** die Sensorplatte (12) und die Abstützelemente (13, 14, 15, 16) einstückig aus einer einzigen rechteckförmigen oder speziell quadratischen Metallplatte in den Richtungen der Diagonalen der Metallplatte freigeschnitten sind, so
**dass** zwischen den streifenförmigen Abstützelementen (13, 14, 15, 16) so eine etwa kleeblattförmige Sensorplatte (12) mit vier, einander jeweils paarweise gegenüberliegenden Sensorflügeln (12a) verbleibt.

2. Elektrischer Mehrwegekraftsensor nach Anspruch 1, **dadurch gekennzeichnet, dass** die Endabschnitte von mindestens zwei Abstützelementen (13, 14) Anschraubaugen ausbilden.

3. Elektrischer Mehrwegekraftsensor nach Anspruch 1, **dadurch gekennzeichnet, dass** die Endabschnitte von mindestens einem Abstützelement (15, 16) Zentrieraugen ausbilden.

4. Elektrischer Mehrwegekraftsensor nach Anspruch 2, **dadurch gekennzeichnet, dass** die Anschraubaugen (17) mit der Leiterplatte (20) verschraubt sind.

5. Elektrischer Mehrwegekraftsensor nach Anspruch 3, **dadurch gekennzeichnet, dass** die Zentrieraugen (18, 19) mit Zentrierstiften (22) an der Leiterplatte (20) zusammenwirken.

6. Elektrischer Mehrwegekraftsensor nach Anspruch 3, **dadurch gekennzeichnet, dass** eines der Zentrieraugen als Langloch (19) ausgeführt ist.

7. Elektrischer Mehrwegekraftsensor nach Anspruch 1, **dadurch gekennzeichnet, dass** die Leiterplatte (20) mehrere Leiterflächen (21) aufweist und dass eine Verschwenkung der Sensorplatte (12) gegen die Leiterflächen (21) der Leiterplatte (20) durch eine kapazitätsmessende Elektronik erfassbar ist.

## Claims

1. Electrical multi-directional force sensor with a sensor pin (11) that can be adjusted from its neutral position in at least two actuation directions and that returns to its neutral position when an actuating force is no longer applied,
with a sensor plate (12) that is connected to the sensor pin (11) and can be pivoted by an adjustment of the sensor pin (11) against a printed circuit board (20) that has an electrical measuring system whose output signal depends on the position of the sensor plate (12),
wherein the sensor plate (12) is integrally connected to a plurality of strip-shaped supporting elements (13, 14, 15, 16), each of which has an end section designed as an eye (17, 18, 19), **characterized in**
**that** the sensor plate (12) and the supporting elements (13, 14, 15, 16) are cut out in one piece from a single rectangular or, in particular, square metal plate in the directions of the diagonals of the metal plate, so
**that** a sensor plate (12) in the shape of a cloverleaf with four sensor wings (12a) arranged opposite each other in pairs remains between the strip-shaped supporting elements (13, 14, 15, 16).

2. Electrical multi-directional force sensor according to claim 1, **characterized in that** the end sections of at least two supporting elements (13, 14) form screw-on eyes.

3. Electrical multi-directional force sensor according to claim 1, **characterized in that** the end sections of at least one supporting element (15, 16) form centering eyes.

4. Electrical multi-directional force sensor according to claim 2, **characterized in that** the screw-on eyes (17) are screwed to the printed circuit board (20).

5. Electrical multi-directional force sensor according to claim 3, **characterized in that** the centering eyes (18, 19) interact with centering pins (22) on the printed circuit board (20).

6. Electrical multi-directional force sensor according to claim 3, **characterized in that** one of the centering eyes is designed as an elongated hole (19).

7. Electrical multi-directional force sensor according to claim 1, **characterized in that** the printed circuit board (20) has a plurality of conductor surfaces (21) and **in that** a pivoting of the sensor plate (12) against the conductor surfaces (21) of the printed circuit board (20) can be detected by capacitance-measuring electronics.

## Revendications

1. Capteur de force électrique multivoies avec un tourillon de capteur (11) réglable à partir de sa position neutre dans au moins deux directions d'actionnement, qui se déplace à nouveau dans sa position neutre en cas de disparition d'une force d'actionnement,
avec une plaque de capteur (12) qui est reliée au tourillon de capteur (11) et qui peut être pivotée par un déplacement du tourillon de capteur (11) contre une carte de circuit imprimé (20) qui présente un système de mesure électrique dont le signal de sortie dépend de la position de la plaque de capteur (12),
la plaque de capteur (12) étant reliée d'un seul tenant à plusieurs éléments de support (13, 14, 15, 16) en forme de bande, qui présentent chacun une section d'extrémité conçue comme un oeil (17, 18, 19),
**caractérisé en ce que**,
la plaque de capteur (12) et les éléments de support (13, 14, 15, 16) sont découpés d'une seule pièce dans une seule plaque métallique rectangulaire ou spécialement carrée dans les directions des diagonales de la plaque métallique, de sorte que
qu'il reste ainsi entre les éléments de support (13, 14, 15, 16) en forme de bande une plaque de détection (12) à peu près en forme de trèfle avec quatre ailes de détection (12a) opposées deux à deux.

2. Capteur de force électrique multivoies selon la revendication 1, **caractérisé en ce que** les sections d'extrémité d'au moins deux éléments de support (13, 14) forment des oeillets de vissage.

3. Capteur de force électrique multivoies selon la revendication 1, **caractérisé en ce que** les sections d'extrémité d'au moins un élément de support (15, 16) forment des oeillets de centrage.

4. Capteur de force électrique multivoies selon la revendication 2, **caractérisé en ce que** les oeillets de vissage (17) sont vissés à la carte de circuit imprimé (20).

5. Capteur de force électrique multivoies selon la revendication 3, **caractérisé en ce que** les oeillets de centrage (18, 19) coopèrent avec des pions de centrage (22) sur la carte de circuit imprimé (20).

6. Capteur de force électrique multivoies selon la revendication 3, **caractérisé en ce que** l'un des oeillets de centrage est réalisé sous forme de trou oblong (19).

7. Capteur de force électrique multivoies selon la revendication 1, **caractérisé en ce que** la carte de circuit imprimé (20) présente plusieurs surfaces conductrices (21) et **en ce qu'**un pivotement de la plaque de capteur (12) contre les surfaces conductrices (21) de la carte de circuit imprimé (20) peut être détecté par une électronique de mesure de la capacité.
